(19) Europäisches Patentamt

European Patent Office

Office européen des brevets

(11) EP 0 631 298 B1

## (12) EUROPEAN PATENT SPECIFICATION

(45) Date of publication and mention
of the grant of the patent:
**30.08.2000 Bulletin 2000/35**

(51) Int. Cl.$^7$: **H01L 21/203**, H01L 29/80

(21) Application number: **94304696.1**

(22) Date of filing: **28.06.1994**

(54) **A method for the production of semiconductor epitaxial substrate**

Ein Verfahren zur Herstellung eines epitaktischen Halbleitersubstrats

Procédé de fabrication d'un substrat semi-conducteur épitaxial

(84) Designated Contracting States:
**DE FR GB**

(30) Priority: **28.06.1993 JP 15685093**

(43) Date of publication of application:
**28.12.1994 Bulletin 1994/52**

(73) Proprietor:
**SUMITOMO CHEMICAL COMPANY LIMITED
Osaka-shi, Osaka 541-0041 (JP)**

(72) Inventors:
• **Hata, Masahiko
Tsukuba-shi, Ibaraki (JP)**
• **Fukuhara, Noboru
Tsukuba-shi, Ibaraki (JP)**
• **Takata, Hiroaki
Tsukuba-shi, Ibaraki (JP)**
• **Inui, Katsumi
Tsukuba-shi, Ibaraki (JP)**

(74) Representative:
**Dixon, Donald Cossar et al
Gee & Co.
Chancery House
Chancery Lane
London WC2A 1QU (GB)**

(56) References cited:
**EP-A- 0 539 693          WO-A-91/13466
US-A- 4 827 320           US-A- 5 162 243**

• **PATENT ABSTRACTS OF JAPAN, unexamined
applications, E field, vol. 14, no. 568, December
16, 1990 THE PATENT OFFICE JAPANESE
GOVERNMENT page 43 E 1014; & JP-A-02 246
344 (SUNYO)**
• **PATENT ABSTRACTS OF JAPAN, unexamined
applications, E field, vol. 16, no. 158, April
17,1992 THE PATENT OFFICE JAPANESE
GOVERNMENT page 116 E 1191; & JP-A-04 010
684 (NOC)**
• **PATENT ABSTRACTS OF JAPAN, unexamined
applications, E field, vol. 17, no. 156, March 26,
1993 THE PATENT OFFICE JAPANESE
GOVERNMENT page 117 E 1341; & JP-A-04 321
239 (SONYO)**

**Description**

The present invention relates to a metalorganic chemical vapour deposition method utilizing metalorganics and/or metalhydrides as the precursors for the production of a semiconductor epitaxial substrate; the substrate is formed on a single crystal gallium arsenide (hereinafter referred to as "GaAs") substrate by an epitaxial growth method.

Various electronic elements using semiconductors have recently been developed and steady development in this industrial field is expected. Until recently silicon has been mainly used industrially as the basic material but a compound semiconductor (e.g., GaAs), which has excellent light-emitting characteristics and high-speed properties, is steadily finding favour.

Various kinds of electronic elements, each having a desired respective performance, can generally be obtained by applying crystal layers having the necessary characteristics to a single crystal substrate by various methods, such as an ion injection method, a diffusion method and an epitaxial growth method. Of these methods, the epitaxial growth method has been widely adopted since with this method not only can the amount of impurities be accurately controlled, but also the composition and thickness of the crystal layer over a wide range.

Known examples of the epitaxial growth method include a liquid phase method, a vapor phase method, and a molecular beam epitaxial method (hereinafter referred to as "MBE method") which is a type of vacuum vapor deposition method. In particular, since the vapor phase method can process a large amount of substrate with good control, the vapor phase method has been widely used on an industrial scale. Among the vapor phase methods, a metalorganic chemical vapor deposition method (hereinafter referred to as "MOCVD method") has recently been widely used.

One type of electric field effect transistor is a high electron mobility transistor (hereinafter sometimes referred to as "HEMT"), which is also sometimes called a modulation doped field effect transistor (MODFET) or heterojunction field effect transistor (HJFRT), which is important as a component part of a low-noise amplifier for microwave communication. The crystals used in electric field effect transistors can be prepared by growing laminated layers of a GaAs crystal and an A1GaAs crystal having the necessary electronic characteristics on a GaAs substrate to provide the necessary structure by the vapor phase method as described above.

As the materials used for preparing these elements, GaAs series materials and AlGaAs series materials have been widely used, since the crystal constants can coincide with each other in desired compositions, and various kinds of heterojunctions are possible while maintaining good crystalline properties.

Since $In_yGa_{(1-y)}As$ ($0<y\leq1$) has excellent electron transport characteristics and the energy gap is greatly changed according to its composition, it has excellent properties as a hetero-junction material. However, since the lattice conformity with GaAs is impossible, there has hitherto been mainly used an InP substrate with which lattice conformity is possible at a value of y of about 0.49.

With the recent progress of techniques in this field, it has been ascertained that, even with a lattice disconformity system, a reliable hetero-junction can be obtained without causing undesirable deterioration of crystalline properties, such as the occurrence of dislocation, if the crystals are within the limit of elastic deformation, by controlling the composition and layer thickness.

By utilizing a strained layer within such specific ranges of composition and layer thickness, a substrate having a InGaAs layer as a part of the epitaxial substrate can be produced, even in an epitaxial substrate employing a GaAs substrate. For example, under ordinary crystal growth conditions, an $In_yGa_{(1-y)}As$ layer of y=0.15 and of about 15 nm in layer thickness can be grown on the GaAs substrate impairment of its crystalline properties. By employing an epitaxial substrate having a structure such that the $Ga_{(1-y)}AsIn_y$ layer is inserted between a GaAs buffer layer and an n-type AlGaAs electron donating layer, an HEMT excellent in noise characteristics, as compared with conventional HEMTs, can be produced.

The epitaxial substrate using GaAs as the substrate and containing the strained layer of InGaAs as a part thereof has been produced by the MBE method or the MOCVD method as described above. However, there are problems with the properties and the productivity of an element using the epitaxial substrate: the MBE method is an epitaxial growth method giving excellent control over the thin layer, but a crystal formed by the MBE method has many surface defects, thus there is a problem with the yield of the elements produced, and also with productivity, as the crystal growth speed is slow and the MBE method requires a super-high vacuum.

US-A-4 827 320 and JP-A-02 246 344 describe such conventional MBE methods.

The MOCVD method gives excellent productivity and the epitaxial substrate obtained by the MOCVD method has fewer surface defects. However, the characteristics of an element employing the resulting epitaxial substrate are not always satisfactory. In the case of an epitaxial substrate prepared under ordinary crystal growth conditions by the MOCVD method and, for example, an $In_{0.15}Ga_{0.85}As$ layer, the layer thickness deviates from 15 nm (the desired value) to have unevenness of about 2 to 5 nm at a period of from 200 to 400 nm. The inventors have found a problem in that the mobility of the two dimensional electron gas traveling in the InGaAs layer is impaired by the unevenness.

An object of the present invention is to provide a method for producing a semiconductor epitaxial substrate in which the unevenness of the growing interface of an $In_yGa_{(1-y)}As$ ($0<y\leq1$) layer, which is a channel layer, is prevented, i.e., the surface of the layer is flattened to improve the two dimensional electron gas mobility.

According to claim 1 of the present invention there is provided a metalorganic chemical vapour deposition method utilizing metalorganics and/or metalhydrides as the precursors for the production of a semiconductor epitaxial substrate, wherein the substrate comprises a strained layer of $In_yGa_{(1-y)}As$($0<y\leq1$) grown on a GaAs substrate or on a GaAs buffer layer, a semiconductor layer of 0.5~5nm in thickness grown on said strained layer of $In_yGa_{(1-y)}As$ and a n-$Al_xGa_{(1-x)}As$ ($0<x\leq1$) layer grown on said semiconductor layer, characterized in that said strained layer of $In_yGa_{(1-y)}As$ is grown on said GaAs substrate or on said GaAs buffer layer at a growth temperature of 625°C or less; said semiconductor layer is grown on said strained layer of $In_yGa_{(1-y)}As$ at a growth temperature of 625°C or less and said n-$Al_xGa_{(1-x)}As$($0<x\leq1$) layer is grown on said semiconductor layer at 650°C or above.

Preferably, the semiconductor layer is a GaAs layer.

Again preferably, the strained layer of $In_yGa_{(1-y)}As$ ($0<y\leq1$)is a strained layer of $In_yGa_{(1-y)}As$ ($0.1\leq y\leq0.3$).

Also preferably, the n-$Al_xGa_{(1-x)}As$($0<x\leq1$) layer is a n-$Al_xGa_{(1-x)}As$ ($0.1\leq x\leq0.3$) layer.

The semiconductor layer and the $In_yGa_{(1-y)}As$ layer may be continuously grown without interruption of crystal growth.

The semiconductor epitaxial substrate as produced according to the present invention is formed on a GaAs single-crystal substrate and has an $In_yGa_{(1-y)}As$ ($0<y\leq1$) crystal layer as a channel layer. The composition and the thickness of the $In_yGa_{(1-y)}As$ layer are within the ranges of the elastic deformation limit of the crystals constituting the $In_yGa_{(1-y)}As$ layer and the vicinity of that layer.

The ranges within the elastic deformation limit can be determined from the relationship of the composition and the layer thickness. The range within the elastic deformation limit of InGaAs to GaAs can be calculated from the following formula (1) given by Mathews et al, J. Crystal Growth, vol. 27, p. 118 (1974) and ibid., vol. 32, p. 265 (1974):

$$\gamma=\frac{a(1-\sigma/4)\,[\ln(Lc2\sqrt{2}/a)+1]}{0.14\sqrt{2}\pi Lc(1+\sigma)} \tag{1}$$

wherein Lc represents the critical layer thickness, $\underline{a}$ represents the lattice constant of GaAs, and $\sigma$ represents the Poisson ratio.

The semiconductor epitaxial substrate as produced according to the present invention further comprises a semiconductor layer between the channel layer and an electron donating layer for supplying electrons to the channel layer. The semiconductor layer has a thickness of from 0.5 to 5 nm and a bandgap width within the range of from the bandgap width of GaAs to the bandgap width of the electron donating layer.

When the semiconductor layer has a bandgap width less than the bandgap width of GaAs, the proportion of the two dimensional electron gas traveling in the semiconductor is increased, whereby the proportion of the two dimensional electron gas traveling in the InGaAs layer, which has excellent electron transport properties, is undesirably decreased.

When the semiconductor layer has a bandgap width greater than the bandgap width of the semiconductor constituting the electron donating layer, the supply of two dimensional electron gas from the electron donating layer to the channel layer is restrained by the semiconductor layer which acts as a barrier, whereby it becomes undesirably difficult to obtain sufficient two dimensional electron gas.

The semiconductor layer has a thickness of from 0.5 to 5 nm, and preferably from 1 to 3 nm. If the thickness thereof is thinner than 0.5 nm, it becomes insufficient to reduce the unevenness of the InGaAs layer: if the thickness thereof is over 5 nm, the distance between the electron donating layer and the channel layer is increased, so that the proportion of the two dimensional electron gas traveling in the semiconductor layer is increased, and the proportion the two dimensional electron gas traveling in the InGaAs layer, which has excellent electron transport properties, is undesirably decreased.

Examples of the electron donating layer of the semiconductor epitaxial substrate of the present invention include semiconductor crystals such as $Al_xGa_{(1-x)}As$ ($0\leq x\leq1$), $Al_xGa_{(1-x)}AS_yP_{(1-y)}$ ($0\leq x\leq1$, $0\leq y\leq1$), and $Zns_xSe_{(1-x)}As$ ($0\leq x\leq1$). In these semiconductor crystals $Al_xGa_{(1-x)}As$ ($0<x\leq1$) is preferred since the lattice constant thereof can coincide with that of GaAs and the production of the hetero-junction, with $Al_xGa_{(1-x)}As$ (0.1 x 0.3) being particularly preferred.

The process for producing the semiconductor epitaxial substrate of the present invention is described in detail below.

As an epitaxial growth method, a vapor phase method is used since a large amount of substrate can be treated with good control. The vapor phase method is a metalorganic chemical vapor deposition method (MOCVD method), in which an organometal compound and/or a metal hydride of the atomic species constituting the epitaxial layer are used as starting materials and thermally decomposed on the substrate to effect crystal growth, this method can be applied to a wide range of materials, and is suitable for accurately controlling the composition of the crystals and the layer thickness.

The $In_yGa_{(1-y)}As$ layer as the channel layer and the semiconductor layer having the specific bandgap width provided between the channel layer and the electron donating layer are epitaxially grown at a temperature of not higher than 625°C, and more preferably not higher than 600°C. If the growth temperature of these layers is over 625°C, the unevenness of the interface of the epitaxial growth is undesirably increased.

The electron donating layer is epitaxially grown at a temperature of at least 650°C, and preferably at least 675°C. If the growth temperature of the layer is lower than 650°C, the amount of the acceptor impurity entering the electron donating layer on crystal growth is increased, thus undesirably reducing the amount of the electrically active and effective donor impurity; furthermore the acceptor impurity becomes the center of electron scattering to impair the electric characteristics of the resulting element.

Layers other than the $In_xGa_{(1-x)}As$ layer constituting the channel layer, namely the semiconductor layer and the electron supplying layer, can be epitaxially grown in the temperature range of generally from 600 to 800°C, and preferably from 650°C to 800°C.

The semiconductor epitaxial substrate as produced according to the present invention can be obtained by laminating various kind of epitaxial crystals on a GaAs single-crystal substrate. For example, in the case of using the combination of crystals of GaAs, $Al_xGa_{(1-x)}As$ (0<x≤1), and $In_yGa_{(1-y)}As$ (0<y<1), the semiconductor epitaxial substrate of this invention can be produced by growing the layers of these crystals on the GaAs single-crystal substrate in the following manner:

(1) The surface of a semi-insulating GaAs single-crystal substrate having a high resistance is subjected to degrease-washing, etching, water-washing, and drying, and the substrate is placed on a stand in a crystal growing furnace.

(2) After sufficiently replacing the internal atmosphere of the furnace with high-purity hydrogen, the furnace is heated. An arsenic starting material is introduced into the furnace at a temperature in the range of generally from 600 to 800°, and preferably from 650 to 800°C, and then a gallium starting material is introduced therein, to grow a non-doped GaAs layer (buffer layer) over the time necessary to achieve a thickness of from 0.1 to 2μm. In place of the non-doped GaAs layer, a non-doped $Al_xGa_{(1-x)}As$ (0<x≤1) layer, or an alternately laminated structure of non-doped $Al_xGa_{(1-x)}As$ (0<x≤1) and non-doped GaAs, may be employed as a buffer layer.

(3) After lowering the temperature below 625°C, preferably below 600°C, an indium starting material is added thereto to grow a non-doped $In_yGa_{(1-y)}As$ (0<x≤1, preferably 0.1 y 0.3) channel layer to 5 to 25 nm, and subsequently a non-doped $Al_yGa_{(1-x)}As$ (0≤x≤0.3), provided that x is smaller than the composition of Al of an n-type AlGaAs layer grown successively) semiconductor layer is grown to 0.5 to 5 nm without interrupting growth. In this case, it is preferred that x of the non-doped $Al_xGa_{(1-x)}As$ is 0, i.e., that the layer is GaAs.

It is preferred that the non-doped $In_yGa_{(1-y)}As$ channel layer and the non-doped $Al_xGa_{(1-x)}As$ semiconductor layer are continuously grown without substantial interruption of crystal growth; for example, that an aluminum starting material is supplied simultaneously with cessation of the supply of the indium starting material.

(4) After cessation of the supply of the indium starting material and increasing the temperature to at least 650°C, preferably at least 675°C, an aluminum starting material is added and non-doped high purity $Al_xGa_{(1-x)}As$ (0.1≤x≤0.3) is grown to a thickness of from 1 to 2 nm. This layer may be omitted. An n-type dopant is then added to grow an n-type $Al_xGa_{(1-x)}As$ (0.1≤x≤0.3) layer (electron donating layer) having a carrier concentration of from $1 \times 10^{18}$ to $3 \times 10^{18}/cm^3$ to a thickness of from 30 to 50 nm. After stopping the supply of the aluminum starting material, n-type GaAs having a carrier concentration of from $2 \times 10^{18}$ to $10 \times 10^{18}/cm^3$ is grown to a thickness of from 30 to 200 nm.

(5) The supply of the gallium starting material is stopped, and then the supply of the arsenic starting material is stopped to terminate crystal growth. After cooling, the resulting epitaxial substrate is taken out from the furnace to complete crystal growth.

As the arsenic starting material, arsenic trihydride (arsine) is preferably used, but a monoalkylarsine (substituting an alkyl group having from 1 to 4 carbon atoms for one hydrogen atom of arsine) may be used.

As the starting materials for gallium, indium, and aluminum, there are preferably used a trialkyl or trihydride compound formed by bonding an alkyl group having from 1 to 3 carbon atoms or hydrogen to each metal atom, and a compound formed by coordinating, on the trialkyl or trihydride compound, a trialkyl compound composed of an alkyl group having from 1 to 4 carbon atoms, and nitrogen or an element selected from phosphorus and arsenic.

As the n-type dopant, a hydride of, for example, silicon, germanium, tin, sulfur or selenium or a $C_{1-3}$ alkyl compound thereof is preferably used.

The values for the composition and layer thickness of each layer of the foregoing semiconductor epitaxial substrate are given for illustrative purposes only, and can in fact be selected in various ranges according to the required characteristics of the element.

In the GaAs substrate being used for the growth of crystals, the angle inclined from the azimuth and the azimuth are not restricted, if the main face azimuth is the {100} face. Examples of the azimuth of the GaAs substrate include the (011) direction perpendicular to the above direction or the azimuth crystallographically equivalent thereto, the (110) direction which has hitherto been used or the azimuth crystallographically equivalent thereto, etc. In these directions of the azimuths, the face azimuth of the substrate is preferably the (011) direction or the azimuth crystallographically equivalent thereto for obtaining a greater flatness of the InGaAs layer or high two dimensional electron gas mobility.

The semiconductor epitaxial substrate produced as described above is excellent in the flatness of the interface between the channel INGaAs layer and the electron donating layer, as compared with conventional substrates, and also has a high electron mobility as compared with conventional ones, whereby high improved device characteristics can be obtained.

The present invention will be described in more detail with reference to the following Examples and Comparative Examples, and the accompanying drawings in which

Fig. 1 is an enlarged schematic cross sectional view showing the semiconductor epitaxial substrate as produced according to this invention prepared in Example 1;

Fig. 2 is an enlarged schematic cross sectional view showing the semiconductor epitaxial substrate prepared in Comparative Example 1;

Fig. 3 is an enlarged schematic cross sectional view showing the semiconductor epitaxial substrate prepared in Comparative Example 2; and

Fig. 4 is a graph showing a photoluminescence emission peak spectrum.

EXAMPLE 1

As a GaAs substrate, the substrate inclined at an angle of 0.5° to the $(0\bar{1}1)$ direction from the {100} face was used.

The following starting materials were used in the metalorganic chemical vapor decomposition method:

Trimethylgallium ($6 \times 10^{-5}$ to $23 \times 10^{-5}$ mol/min)
Trimethylaluminum ($1.3 \times 10^{-5}$ mol/min)
Trimethylindium ($5.6 \times 10^{-5}$ mol/min)
Arsine ($4.5 \times 10^{-3}$ mol/min)
Disilane as an n-type dopant ($2.2 \times 10^{-8}$ to $2.5 \times 10^{-8}$ mol/min)

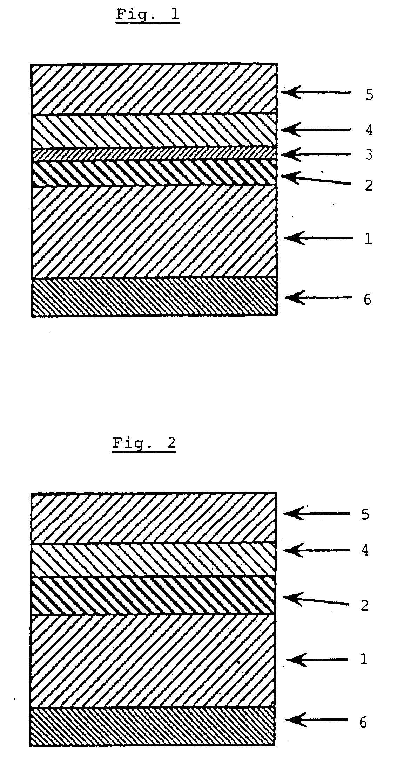

A semiconductor substrate for HEMT was prepared by laminating successive layers 1 to 5 onto the GaAs substrate under the conditions shown in Table 1 below. Fig. 1 is a schematic sectional view of the semiconductor substrate and numerals 1 to 5 denote layers 1 to 5, respectively, and numeral 6 the GaAs substrate.

The thermal decompositions of the starting materials were carried out at a pressure of 76 Torr using 45 liters/minute of hydrogen purified by permeation through a palladium membrane.

In Table 1 below, trimethylgallium, trimethylaluminum, and trimethylindium are shown as TMG, TMA and TMI, respectively.

The $In_{0.20}Ga_{0.80}As$ layer of 12 nm in thickness as layer 2 had a composition within the elastic deformation limit and the layer thickness given by formula (1) set forth above. After growing layer 2, layer 3, the GaAs layer, of 2 nm thickness was grown without substantially interrupting crystal growing after growing layer 2 by stopping the supply of trimethylindium while continuously supplying trimethylgallium.

TABLE 1

| Layer | Constitution | Layer thickness | Growing temperature (°C) | Starting material |
|---|---|---|---|---|
| Layer 1 | Buffer layer: Non-doped GaAs | 0.5 μm | 700 | TMG Arsine |

TABLE 1 (continued)

| Layer | Constitution | Layer thickness | Growing temperature (°C) | Starting material |
|---|---|---|---|---|
| Layer 2 | Channel layer: $In_{0.20}Ga_{0.80}As$ | 12 nm | 600 | TMG |
| | | | | TMI |
| | | | | Arsine |
| Layer 3 | Semiconductor layer: GaAs | 2 nm | 600 | TMG |
| | | | | Arsine |
| Layer 4 | Electron donating layer: n-$Al_{0.20}Ga_{0.80}As$ (doped amount: n = $2 \times 10^{18}$ cm$^{-3}$) | 50 nm | 700 | TMG |
| | | | | TMA |
| | | | | Arsine |
| | | | | Disilane |
| Layer 5 | N-GaAs | 80 nm | 700 | TMG |
| | | | | Arsine |
| | | | | Disilane |

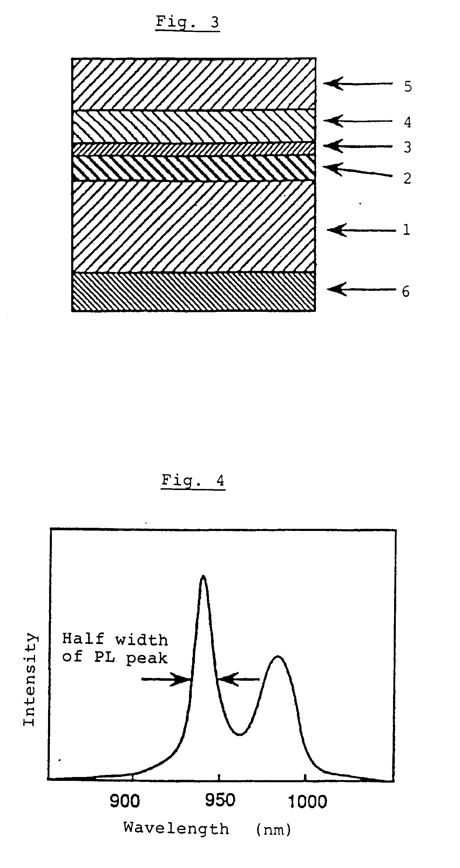

The two dimensional electron gas mobility at 77K of the resulting semiconductor substrate obtained was evaluated by a Hall measurement, and found to be 25,000 cm$^2$/Vs. The half width of photoluminescent emission peak (hereinafter referred to as "PL peak") observed in the wavelength range of from 920 to 950 nm measurable by 77K in the PL peaks was 19.7 meV. The half width of PL peaks is the energy width of the range that the PL emission intensity becomes 1/2 as shown in Fig. 4. It shows the flatness of the InGaAs layer, and as the value is large, the flatness is inferior.

COMPARATIVE EXAMPLE 1

A semiconductor substrate was prepared by following the same procedure as in Example 1 except that the growth of the $In_{0.20}Ga_{0.80}As$ layer (layer 2) was carried out at a substrate temperature of 700°C and then the growth of the AlGaAs layer (Layer 4), which is an electron donating layer, was carried out. The schematic sectional view of the semiconductor substrate is shown in Fig. 2. The two dimensional electron gas mobility at 77K was evaluated by a Hall measurement and found to be 9,700 cm$^2$/Vs. The half width of the PL peak was 31.8 meV. The cross section of the crystals was observed by transmission electron microscope (TEM) of a high resolving power, and a wavy unevenness arranged in one direction was observed on the surface of the InGaAs crystal. The period of the wavy unevenness was from 200 to 400 nm and the height of the unevenness was 2 nm or higher.

COMPARATIVE EXAMPLE 2

A semiconductor substrate was prepared following the same procedure as in Example 1 except that the growth of the $In_{0.20}Ga_{0.80}As$ layer (layer 2) was carried out at a substrate temperature of 600°C and, after changing the substrate temperature to 700°C, the growth of the GaAs layer (layer 3) was carried out. The schematic sectional view of the semiconductor substrate is shown in Fig. 2. The two dimensional electron gas mobility of the crystals at 77K was evaluated by a Hall measurement and found to be 17,500 cm$^2$/Vs. The half width of the PL peak was 31.3 meV. The cross section of the crystals was observed by TEM, and a wavy unevenness arranged in one direction was observed on the surface of the InGaAs crystal. The period thereof was from 200 to 400 nm and the height of the unevenness was 2 nm or higher.

By using the epitaxial substrate as produced according to the present invention, a large amount of electron elements having good characteristics can be produced at a low cost in various kinds of electron elements using an InGaAs layer formed on a GaAs substrate, and thus the industrial significance thereof is very large.

The semiconductor epitaxial substrate as produced according to the present invention is excellent in the flatness of the interface between the channel InGaAs layer and the electron donating layer, as compared with conventional substrates; and it has a high electron mobility as compared with conventional crystals, whereby high improved device characteristics can be obtained.

When the semiconductor epitaxial substrate is used for a field effect transistor in which $In_yGa_{(1-y)}As$ (0<y≤1) forms the channel layer, there can be prepared an HEMT having an excellent performance without impairment of the two dimensional electron gas mobility by unevenness at the growth interface of the channel layer.

## Claims

1. A metalorganic chemical vapour deposition method utilizing metalorganics and/or metalhydrides as the precursors for the production of a semiconductor epitaxial substrate, wherein the substrate comprises a strained layer of $In_yGa_{(1-y)}As(0<y\leq1)$ grown on a GaAs substrate or on a GaAs buffer layer, a semiconductor layer of 0.5~5nm in thickness grown on said strained layer of $In_yGa_{(1-y)}As$ and a n-$Al_xGa_{(1-x)}As(0<x\leq1)$ layer grown on said semiconductor layer, characterized in that said strained layer of $In_yGa_{(1-y)}As$ is grown on said GaAs substrate or on said GaAs buffer layer at a growth temperature of 625°C or less; said semiconductor layer is grown on said strained layer of $In_yGa_{(1-y)}As$ at a growth temperature of 625°C or less and said n-$Al_xGa_{(1-x)}As(0<x\leq1)$ layer is grown on said semiconductor layer at 650°C or above.

2. A method as claimed in Claim 1, wherein said semiconductor layer is a GaAs layer.

3. A method as claimed in Claim 1 or 2, wherein said strained layer of $In_yGa_{(1-y)}As(0<y\leq1)$ is a strained layer of $In_yGa_{(1-y)}As(0.1\leq y\leq0.3)$.

4. A method as claimed in any preceding claim, wherein said n-$Al_xGa_{(1-x)}As(0<x\leq1)$ layer is a n-$Al_xGa_{(1-x)}As$ $(0.1\leq x\leq0.3)$ layer.

5. A method as claimed in any preceding claim, wherein said semiconductor layer and said $In_yGa_{(1-y)}As$ layer are continuously grown without interruption of crystal growth.

## Patentansprüche

1. Verfahren zur Dampfabscheidung einer metallorganischen chemischen Verbindung unter Verwendung von metallorganischen Verbindungen und/oder Metallhydriden als Vorstufen zur Herstellung eines epitaktischen Halbleitersubstrats, wobei das Substrat eine gedehnte $In_yGa_{(1-y)}As(0<y\leq1)$-Schicht, die auf einem GaAs-Substrat oder auf einer GaAs-Pufferschicht gewachsen ist, eine Halbleiterschicht mit 0,5 ~ 5 nm Dicke, die auf der gedehnten $In_yGa_{(1-y)}As$-Schicht gewachsen ist, und eine n-$Al_xGa_{(1-x)}As(0<x\leq1)$-Schicht, die auf der Halbleiterschicht gewachsen ist, umfasst, dadurch gekennzeichnet, dass man die gedehnte $In_yGa_{(1-y)}As$-Schicht auf dem GaAs-Substrat oder auf der GaAs-Pufferschicht bei einer Wachstumstemperatur von 625°C oder tiefer aufwachsen lässt; die Halbleiterschicht auf der gedehnten $In_yGa_{(1-y)}As$-Schicht bei einer Wachstumstemperatur von 625°C oder tiefer aufwachsen lässt und die n-$Al_xGa_{(1-x)}As(0<x\leq1)$-Schicht bei 650°C oder höher auf der Halbleiterschicht aufwachsen lässt.

2. Verfahren nach Anspruch 1, wobei die Halbleiterschicht eine GaAs-Schicht ist.

3. Verfahren nach einem der Ansprüche 1 oder 2, wobei die gedehnte $In_yGa_{(1-y)}As(0<y\leq1)$-Schicht eine gedehnte $In_yGa_{(1-y)}As(0,1\leq y\leq0,3)$-Schicht ist.

4. Verfahren nach einem der vorstehenden Ansprüche, wobei die n-$Al_xGa_{(1-x)}As(0<x\leq1)$-Schicht eine n-$Al_xGa_{(1-x)}As(0,1\leq x\leq0,3)$-Schicht ist.

5. Verfahren nach einem der vorstehenden Ansprüche, wobei man die Halbleiterschicht und die $In_yGa_{(1-y)}As$-Schicht ohne Unterbrechung des Kristallwachstums kontinuierlich aufwachsen lässt.

## Revendications

1. Procédé de dépôt chimique en phase vapeur d'organométalliques en utilisant des organo-métalliques et/ou des hydrures métalliques en tant que précurseurs pour la production d'un substrat épitaxial semiconducteur, dans lequel le substrat comprend une couche sous contrainte en $In_yGa_{(1-y)}As$ (0 < y ≤ 1) obtenue par croissance sur un substrat en GaAs ou sur une couche tampon en GaAs, une couche semiconductrice d'une épaisseur de 0,5 à 5 nm obtenue par croissance sur ladite couche sous contrainte en $In_yGa_{(1-y)}As$ et une couche en n-$Al_xGa_{(1-x)}As$ (0 < x ≤ 1) obtenue par croissance sur ladite couche semiconductrice, caractérisé en ce que ladite couche sous contrainte en $In_yGa_{(1-y)}As$ est obtenue par croissance sur ledit substrat en GaAs ou sur ladite couche tampon en GaAs à une température de croissance de 625°C ou moins; ladite couche semiconductrice est obtenue par croissance sur ladite couche sous contrainte en $In_yGa_{(1-y)}As$ à une température de croissance de 625°C ou moins et ladite couche en $n-Al_xGa_{(1-x)}As$ ($0 < x \leq 1$) est obtenue par croissance sur ladite couche semiconductrice à 650°C ou plus.

2. Procédé selon la revendication 1, dans lequel ladite couche semiconductrice est une couche en GaAs.

3. Procédé selon la revendication 1 ou 2, dans lequel ladite couche sous contrainte en $In_yGa_{(1-y)}As$ ($0 < y \leq 1$) est une couche sous contrainte en $In_yGa_{(1-y)}As$ ($0,1 \leq y \leq 0,3$).

4. Procédé selon l'une quelconque des revendications précédentes, dans lequel ladite couche en $n-Al_xGa_{(1-x)}As$ ($0 < x \leq 1$) est une couche en $n-Al_xGa_{(1-x)}As$ ($0,1 \leq x \leq 0.3$).

5. Procédé selon l'une quelconque des revendications précédentes, dans lequel ladite couche semiconductrice et ladite couche en $In_yGa_{(1-y)}As$ sont obtenues par croissance continue sans interruption de la croissance cristalline.

Fig. 1

Fig. 2

Fig. 3

Fig. 4